# EUROPÄISCHE PATENTSCHRIFT

(11) **EP 1 474 091 B1**
(45) Veröffentlichungstag und Bekanntmachung des Hinweises auf die Patenterteilung: **14.12.2011**
(21) Anmeldenummer: 03739426.9
(22) Anmeldetag: 23.01.2003
(51) Int. Cl.: A61J 7/04, A61J 1/03

(54) **BLISTERPACKUNGSANORDNUNG**
BLISTER PACK SYSTEM
SYSTEME D'EMBALLAGE TRANSPARENT

(30) Priorität: 14.02.2002 DE 10206138
(43) Veröffentlichungstag der Anmeldung: 10.11.2004
(73) Patentinhaber: Simon, Udo, 90409 Nürnberg (DE); Radtke, Ernst-Rudolf, 91207 Lauf a. d. Peg. (DE)
(72) Erfinder: Simon, Udo, 90409 Nürnberg (DE); Radtke, Ernst-Rudolf, 91207 Lauf a. d. Peg. (DE)
(74) Vertreter: von Puttkamer, Nikolaus
(86) Internationale Anmeldenummer: PCT/DE2003/000179
(87) Internationale Veröffentlichungsnummer: WO 2003/068137

(56) Entgegenhaltungen:
- WO-A-96/04881
- DE-A- 3 518 531
- US-A- 4 125 190
- US-A- 4 526 474
- US-A- 4 660 991

## Beschreibung

Die vorliegende Erfindung betrifft eine Blisterpackungsanordnung nach dem Oberbegriff des Patentanspruches 1.

Aus der US PS 4 526 474 geht beispielsweise eine Einrichtung hervor, die einen Patienten an eine Dragee-Entnahme erinnert. Dabei wird eine Blisterpackung in eine Haltevorrichtung eingesetzt, die eine Elektronikeinheit umfasst, damit ein Patient zur rechten Zeit an die Entnahme eines Dragees aus der Blisterpackung erinnert werden kann und damit die tatsächlichen Entnahmezeitpunkte von Dragees in einem Speicher der Elektronikeinheit erfasst und ggf. zu einer zentralen Datenverarbeitungseinrichtung übertragen werden können.
Die Impulse, die eine Dragee-Entnahme anzeigen, werden bei der Unterbrechung einer elektrischen Leiterbahn erzeugt.

Hierzu verläuft über jede Drageetasche der Blisterpackung eine Leiterbahn, wobei jeweils das eine Ende der Leiterbahn mit einer gemeinsamen Leiterbahn und das andere Ende der Leiterbahn mit einer individuellen Leiterbahn verbunden ist.
Die Leiterbahnen sind auf der, die einzelnen Drageetaschen versiegelnden Folie des Blisters angeordnet. Vom Blister aus verlaufen die gemeinsame Leiterbahn und die individuellen Leiterbahnen über die Gegenkontakte der Haltevorrichtung und deren Leiterbahnen zur Elektronikeinheit.

Aus der US PS 4 660 991 geht eine weitere Vorrichtung zum Halten einer Blisterpackung hervor, bei der anstelle der die einzelnen Drageebecher versiegelnde Folie mit Leiterbahnen ein mit Leiterbahnen bedrucktes, durchdrückbares Material (z.B. spezielles Papier), in die Haltevorrichtung eingelegt wird, das von den Gegenkontakten der Haltevorrichtung beaufschlagt wird.

Auch diese Vorrichtung besitzt eine Elektronikeinheit mit einem zeitgeber, der zum Zeitpunkt der Entnahme eines ersten Dragees aus der Blisterpackung einen elektrischen Startimpuls zur Aktivierung des Zeitgebers aufnimmt und der zu vorbestimmten Zeiten ein Ton- und/oder optisches Signal aussendet.

### (Erinnerungsfunktion)

Die Vorrichtung umfasst einen Trägerrahmen, der die Randbereiche oder Ecken der Blisterpackung wenigstens teilweise umgibt und an seiner unteren Seite wenigstens teilweise offen ist, damit die Drageeentnahme aus einer in dem Trägerrahmen enthaltenen Blisterpackung möglich ist.

Aus der WO 96/04881 A geht eine gattungsgemäße Blisterpackungsanordnung zum zeitgerechten Einnehmen von Medikamenten hervor. Dabei weist diese Blisterpackungsanordnung auf ihrer Unterseite die Taschen der Blisterpackung kreuzende Leiterbahnen auf. Die mit diesen Leiterbahnen versehene Blisterpackung kann auf eine Platine aufgelegt werden, die Öffnungen besitzt, die zu den Taschen der Blisterpackung ausgerichtet werden können. Die Blisterpackung und die dazu ausgerichtete Platine werden zusammen in ein Gehäuse eingeschoben, dessen Bodenwand ebenfalls zu den Taschen der Blisterpackung ausrichtbare Öffnungen aufweist. In dem Gehäuse ist eine Elektronikvorrichtung zur Erfassung der Medikamententnahme vorgesehen.

Die Aufgabe der vorliegenden Erfindung besteht darin, eine Blisterpackungsanordnung so auszugestalten, dass eine sichere Erfassung der Drageeentnahme durch eine Elektronikvorrichtung ermöglicht wird.

Diese Aufgabe wird durch eine Blisterpackungsanordnung mit den Merkmalen des Patentanspruches 1 gelöst.

Bei der erfindungsgemäßen Blisterpackungsanordnung sind die Kontaktflecken des Blisters und die Kontaktflecken der Leiterplatte jeweils durch einen leitfähigen Kleber dauerhaft verbunden. Vorteilhaft ist dabei, dass durch diese dauerhafte Verbindung eine sichere Kontaktierung zwischen Blister und Leiterplatte gewährleistet ist.

Ein besonderer Vorteil einer Ausgestaltung der vorliegenden Erfindung besteht darin, dass die vorliegende Blisterpackungsanordnung so ausgestaltet ist, dass eine Drageeentnahme durch Kinder vermieden wird.

Dies wird durch eine Deckschicht erreicht, die auf die Unterseite der Leiterplatte aufgebracht ist. Vor der Entnahme eines Dragees aus der Blisterpackung muss ein Abziehstreifen von der Leiterplattedeckschicht abgezogen werden, der den Durchdrückbereich eines Dragees auf der Leiterplatte abdeckt. Erst nach Abziehen des Streifens kann das Dragee durch vorgestanzte Bereiche ausgedrückt werden. Die dem Dragee zugeordnete Leiterbahn des Blisters wird dabei irreversibel durchtrennt und die Elektronik erkennt die Zustandsveränderung des Blister.

Ein weiterer, wesentlicher Vorteil einer Weiterbildung der vorliegenden Erfindung besteht darin, dass beim Einstecken einer Blisterpackungsanordnung in die Haltevorrichtung sichergestellt ist, dass die Leiterplatte automatisch in die richtige Steckverbindungslage gerät.
Eine asymmetrische Anordnung von Führungselementen, vorzugsweise Stanzungen lassen nur eine eindeutige Positionierung der Blisterpackungsanordnung in der Haltevorrichtung zu.

Fehlerhafte Signalerfassungen durch fehlerhaftes Einstecken der Blisterpackungsanordnung in die Haltevorrichtung können sicher vorteilhafterweise vermieden werden. Dies wird dadurch erreicht, dass die Elektronikeinheit erst dann aktiviert wird, wenn sich die Blisterpackungsanordnung in der richtigen Steckkontaktlage befindet. Dadurch können Probleme vermieden werden, die auf Vorgänge beim Einstecken der Blisterpackungsanordnung in die Haltevorrichtung zurückzuführen sind. Solche Vorgänge können nach der Herstellung einer individuellen elektrischen Verbindung zwischen der Blisterpackungsanordnung und der Elektronikeinheit bei Relativbewegungen zwischen der Blisterpackungsanordnung und der Haltevorrichtung beim Einstecken zu Kontaktunterbrechungen führen, die eine Drageeentnahme simulieren könnten.

Eine Kodierung der Leiterplatte durch Stanzungen, Lochungen, Schlitzungen, Barcode oder elektronische Verfahren etc. ermöglicht eine Erkennung durch die Elektronikeinheiten, welches Arzneimittel in einem Blister untergebracht ist. Diese Kodierung ist z.B. durch die Stanzung von Schlitzen auf der Leiterplatte möglich, die geschlossene Kontakte der Elektronikeinheit unterbricht oder durch das Aufdrucken von leitfähigen Kontaktflecken, deren unterschiedliche Anordnung einem entsprechenden, im Blister enthaltenen Arzneimittel zugeordnet werden kann.

Vorteilhafterweise sind bei einer bevorzugten Ausgestaltung der Erfindung eine wirtschaftliche sinnvolle Herstellung und das lageorientierte Zusammenführen von Blister und Leiterplatte gewährleistet. Dies wird dadurch gelöst, dass auf der leiterbahnführenden Abdeckfolie des Blisters eine oder mehrere Passermarken aufgedruckt sind, die z.B. von einem optischen Steuergerät durch ein oder mehrere Fenster der Leiterplatte gelesen werden können.

Um den Verbund zwischen Blister und Leiterplatte zu optimieren werden die Randbereiche des Blisters umlaufend mit einem nichtleitenden Kleber verbunden. Somit ist eine weitgehend dauerhafte Verbindung zwischen Blister und Leiterplatte sichergestellt.

Im folgenden werden die Erfindung und deren Ausgestaltungen im Zusammenhang mit den Figuren näher erläutert. Es zeigen:
Figur 1 eine Blisterpackung der erfindungsgemäßen Blisterpackungsanordnung von oben her gesehen;
Figur 2 die Blisterpackung der Figur 1 von unten her gesehen, wobei der spezielle Verlauf der gemeinsamen Leiterbahn und der individuellen Leiterbahnen sichtbar ist;
Figur 3 eine Leiterplatte mit Leiterbahnen und Öffnungen zur Drageeentnahme von oben her gesehen;
Figuren 4, 4a und 4b die Leiterplatte der Figur 3 von oben her gesehen, mit aufgelegter Blisterpackung. Zur Erläuterung: verschiedene Merkmale der Erfindung, wobei die Figur 4a die Blisterpackungsanordnung vor dem Einschieben in das Aufnahmeteil und die Figur 4b die Blisterpackungsanordnung nach dem Einschieben in das Aufnahmeteil zeigen.
Figur 5 eine teilweise mit Abziehstreifen versehene Leiterplatte;
Figur 6 einen Schnitt durch die vorliegende Blisterpackungsanordnung in Längsrichtung, wobei die Leiterplatte und die eigentliche Blisterpackung noch nicht zum Gebrauch miteinander verbunden sind;
Figur 7 die Blisterpackungsanordnung der Figur 6, wobei die Blisterpackung und die Leiterplatte zum Gebrauch miteinander verbunden sind; und
Figuren 8 bis 10 Weiterbildungen der Erfindung.

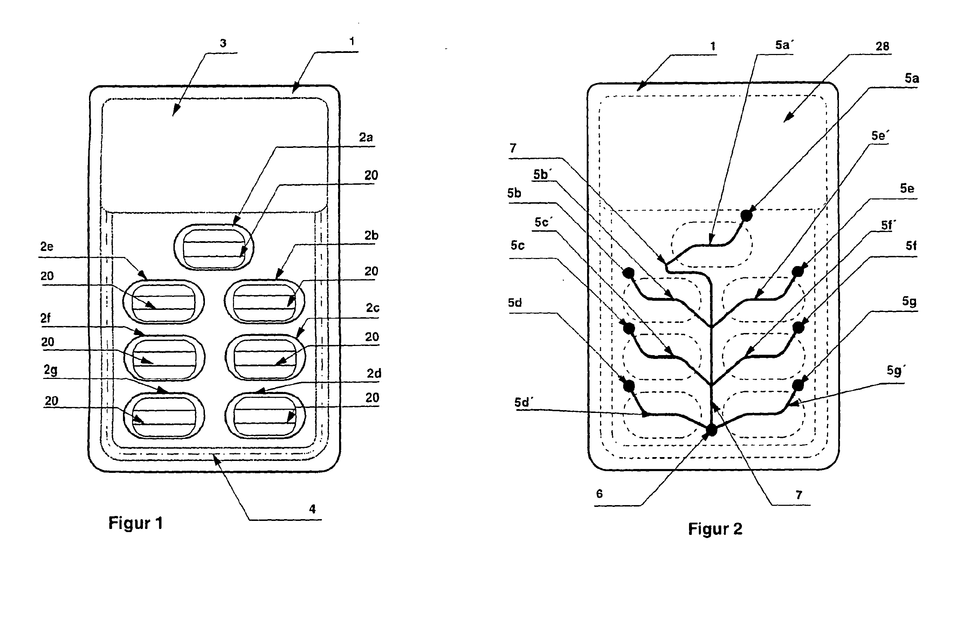

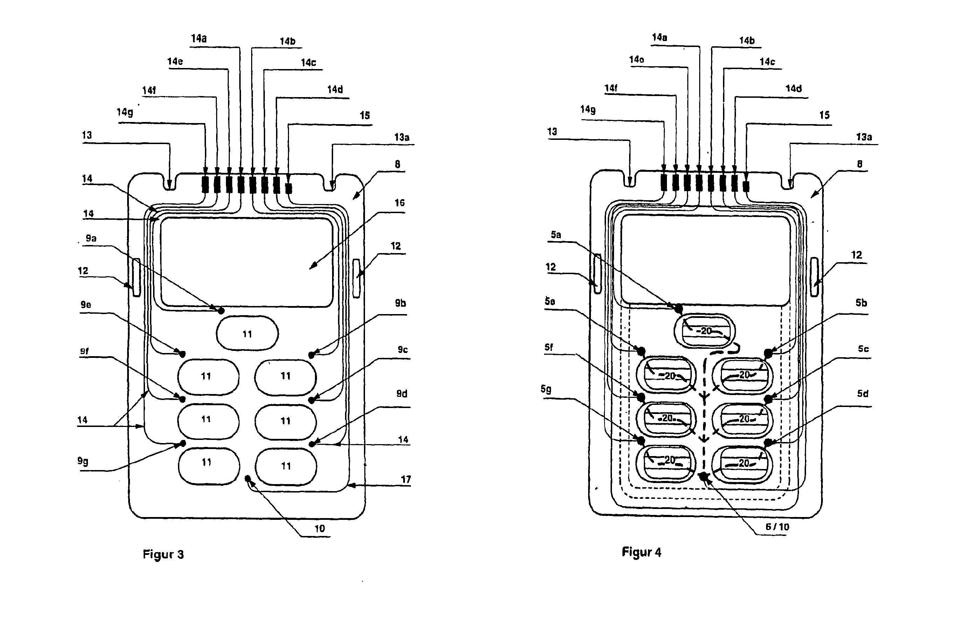

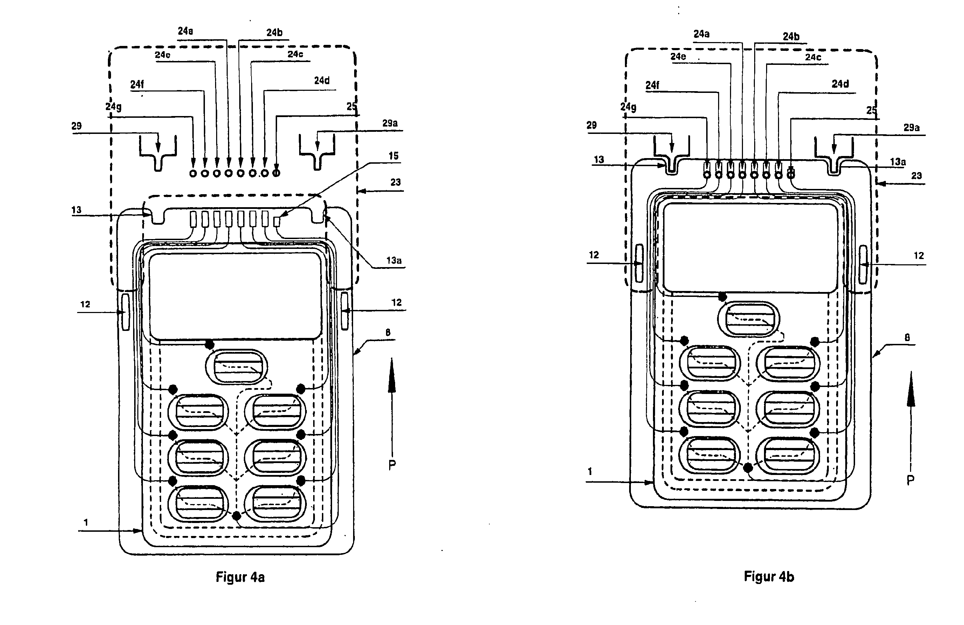

Die vorliegende Blisterpackungsanordnung besteht im wesentlichen aus einer aus den Figuren 1 und 2 ersichtlichen Blisterpackung 1, die in an sich üblicherweise mehrere Dragee-Becher bzw. Taschen 2a bis 2g zur Aufnahme von Medikamenten, insbesondere Tabletten, Pillen oder Dragees 20 besitzt, und einer Leiterplatte 8 (Figuren 3 und 4). Vorzugsweise weist die Blisterpackung 1 in Längsrichtung verlaufend zwei nebeneinander angeordnete Taschenreihen mit jeweils drei Taschen 2b, 2c, 2d bzw. 2e, 2f, 2g und eine an den einen Enden der sich gegenüberliegenden Reihen mittig angeordnete weitere Tasche 2a auf. Beispielsweise an der den beiden Taschenreihen abgewandeten Seite der mittleren Tasche 2a kann ein größeres taschenförmiges Abteil 3 angeordnet sein, in dem ein gefalteter Beipackzettel oder dergleichen angeordnet sein kann. Andere Taschenanordnungen sind möglich.

Unterseitig ist gemäß der Figur 2 eine die Taschen 2a bis 2g und das Abteil 3 versiegelnde Folie 28 angeordnet. Zur Verstärkung der Blisterpackung 1 kann eine wenigstens teilweise entlang des Außenrandes verlaufende Sicke 4 vorgesehen sein (vgl. Fig. 1)

Auf der Folie 28 sind außenseitig gemäß Figur 2 verschiedene Kontaktflecken 5a bis 5g angeordnet, von denen jeweils ein Kontaktfleck den Taschen 2a bis 2g zugeordnet und in deren Nähe angeordnet ist. Von jedem Kontaktfleck 5a bis 5g aus verläuft eine individuelle Leiterbahn 5a' bis 5g' auf der Außenseite der Folie 28 über die entsprechende Tasche 2a bis 2g zu einer vorzugsweise zwischen den beiden Taschenreihen zentral verlaufendem gemeinsamen Leiterbahn 7, die mit einem gemeinsamen Kontaktfleck 6 verbunden ist. Durch diese Anordnung ist sichergestellt, dass im verschlossenen Zustand der Blisterpackung 1 von dem gemeinsamen Kontaktfleck 6 aus eine elektrische Verbindung über jeweils eine über eine Tasche 2a bis 2g verlaufende Leiterbahn 5a' bis 5g' zu dem der jeweiligen Tasche 2a bis 2g jeweils zugeordneten Kontaktfleck 5a bis 5g besteht. Im Falle einer Drageeentnahme aus einer Tasche wird die der Tasche zugeordnete elektrische Verbindung zwischen dem gemeinsamen Kontaktfleck 6 und dem jeweiligen Kontaktfleck 5a bis 5g unterbrochen.

Der so ausgestalteten Blisterpackung 1 ist die bereits erwähnte Leiterplatte 8 zugeordnet, die aus den Figuren 3 und 4 ersichtlich ist. Entsprechend dem Muster der Kontaktflecken 5a bis 5g und 6 der Blisterpackung 1 weist die Leiterplatte 8 an ihrer einen Seite ein Muster von individuellen Kontaktflecken 9a bis 9g und einem gemeinsamen Kontaktfleck 10 auf, wobei die Kontaktflecken 9a bis 9g deckungsgleich zu den Kontaktflecken 5a bis 5g der Blisterpackung 1 und der Kontaktfleck 10 deckungsgleich zu dem Kontaktfleck 6 der Blisterpakkung 1 ausrichtbar sind, wenn die Unterseite der Blisterpakkung 1 auf die die Kontaktflecken 9a bis 9g und 10 aufweisende Fläche der Leiterplatte 8 aufgelegt wird.

Entsprechend dem Muster der Taschen 2a bis 2g und des Abteils 3 der Blisterpackung 1 weist die Leiterplatte 8, die vorzugsweise aus einem insbesondere flexiblen PVC-Material besteht, den Taschen 2a bis 2g entsprechende Durchstanzungen 11 und eine dem Abteil 3 entsprechende Durchstanzung 16 auf, die zu den Taschen 2a bis 2g bzw. dem Abteil 3 ausrichtbar sind.

Die Leiterplatte 8 ist vorzugsweise so bemessen, dass sie nach ihrer später erläuterten Befestigung an der Blisterpakkung 1 an allen Seiten über die Blisterpackung 1 übersteht.

Die Figur 4 zeigt von oben her gesehen den Zustand, in dem die Leiterplatte 8 an der Blisterpackung 1 befestigt ist, wobei dann die Kontaktflecken 5a bis 5g der Blisterpackung 1 (vgl. Fig. 2) mit den entsprechenden Kontaktflecken 9a bis 9g (vgl. Fig. 3,4) der Leiterplatte 8 und der gemeinsame Kontaktfleck 6 der Blisterpackung 1 mit dem gemeinsamen Kontaktfleck 10 der Leiterplatte 8 elektrisch verbunden sind.

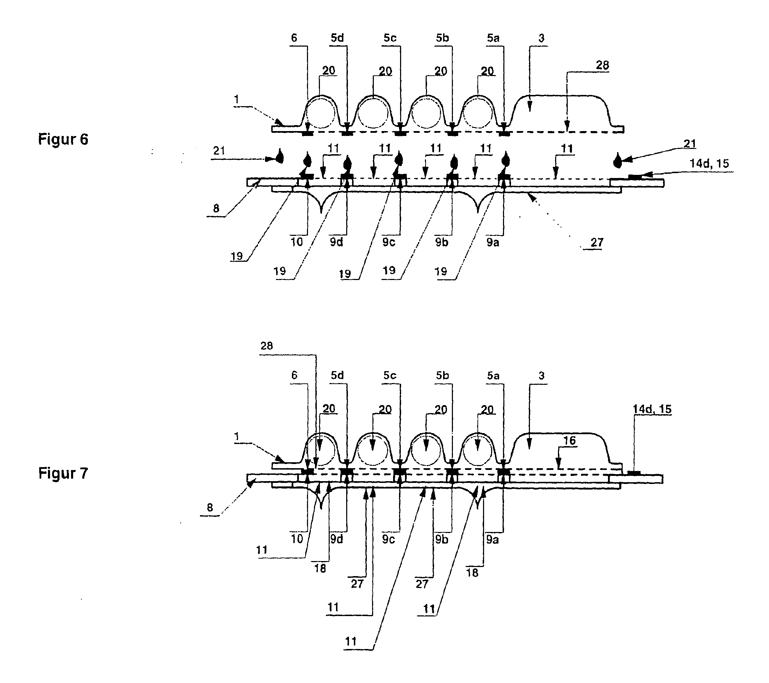

Gemäß Figur 6 wird dies dadurch erreicht, dass die Leiterplatte 8 und die Blisterpackung 1 nach Anordnung von Leitkleberpunkten 19 auf den Kontaktflecken 5a bis 5d und 6 der Folie 28 der Blisterpackung 1 oder auf den Kontaktflächen 9a - 9g und 10 der Leiterplatte 8 zueinander ausgerichtet und aufeinander gepresst werden. Dabei entstehen nach dem Aushärten der Leitkleberpunkte 19 elektrische Verbindungen zwischen den einander zugeordneten Kontaktflecken 5a bis 5g der Blisterpackung 1 und den Kontaktflecken 9a bis 9g der Leiterplatte 8. Dieser Zustand ist in der Figur 7 dargestellt.

Wie die Figur 3 zeigt, befinden sich an einer Seite, vorzugsweise einer Stirnseite der Leiterplatte 8 individuelle Anschlusskontaktflecken 14a bis 14g und ein gemeinsamer Anschlusskontaktfleck 15 vorzugsweise nebeneinander in einer Reihe. Jeder individuelle Anschlussfleck 14a bis 14g ist über eine individuelle Leiterbahn 14 mit einem bestimmten Kontaktfleck 9a bis 9g der Leiterplatte 8 verbunden. Der gemeinsame Anschlusskontaktfleck 15 ist über eine gemeinsame Leiterbahn 17 mit dem gemeinsamen Kontaktfleck 10 der Leiterplatte 8 verbunden. Somit bestehen bei der fertig hergestellten Blisterpackungsanordnung gemäß den Figuren 4 und 7 elektrische Verbindungen zwischen jedem individuellen Anschlusskontaktfleck 14a bis 14g, über eine individuelle Leiterbahn 14, einen individuellen Kontaktfleck 9a bis 9g der Leiterplatte 8, einen Leitkleberpunkt 19, einen individuellen Kontaktfleck 5a bis 5g der Blisterpackung 1, eine individuelle Leiterbahn 5a' bis 5g' der Blisterpackung 1, die gemeinsame Leiterbahn 7 der Blisterpackung 1, den gemeinsamen Kontaktfleck 6 der Blisterpackung 1, den entsprechenden Leitkleberpunkt 19, den entsprechenden gemeinsamen Kontaktfleck 10 der Leiterplatte 8 und die gemeinsame Leiterbahn 17 derselben zu dem gemeinsamen Anschlusskontaktfleck 15.

Bei der Entnahme eines Dragees 20, beispielsweise bei der Entnahme des links angeordneten Dragees 20 in Figur 7, werden die Folie 28 und die entsprechende Leiterbahn 5d' durchbrochen, sodass die entsprechende elektrische Verbindung zur Anzeige der speziellen Drageeentnahme unterbrochen wird. Alle anderen elektrischen Verbindungen bleiben dabei bestehen.

Die vorliegende Blisterpackungsanordnung wird gemäß den Figuren 4a,b in ein schematisch dargestelltes Aufnahmeteil 23 einer nicht näher dargestellten Haltevorrichtung eingeschoben, wobei die im Aufnahmeteil 23 (oder in der Haltevorrichtung) enthaltene Elektronikeinheit bzw. ein Elektronikmodul (nicht dargestellt) über die individuellen Anschlußkontakte 24a bis 24g und 25 mit den individuellen Anschlußkontaktflecken 14a bis 14g und 15 (vgl. Fig. 4) der Blisterpackung 1 verbunden wird.

Um zu verhindern, dass beim Einschieben ein Stromfluss zwischen dem gemeinsamen Anschlusskontaktfleck 25 des Aufnahmeteiles 23 und einem individuellen Anschlusskontaktfleck 24a bis 24g des Aufnahmeteiles 23 zunächst hergestellt und beim weiteren Einschieben der Blisterpackungsanordnung in das Aufnahmeteil 23 wieder unterbrochen wird, was von der Elektronikeinheit fälschlicherweise als Drageeentnahme gedeutet würde, ist in der Einschubrichtung P der gemeinsame Anschlusskontaktfleck 15 der Leiterplatte 8 kürzer bemessen als die individuellen Anschlusskontaktflecken 14a bis 14g der Leiterplatte 8, sodass ein Kontakt zwischen dem gemeinsamen Anschlußkontaktfleck 15 der Leiterplatte 8 und dem ihm zugeordneten gemeinsamen Kontaktfleck 25 des Aufnahmeteiles 23 erst dann hergestellt wird, wenn bereits zwischen den individuellen Anschlusskontaktflecken 14a bis 14g der Leiterplatte 8 und den zugeordneten individuellen Anschlußkontaktflecken 24a bis 24g des Aufnahmeteiles 23 sicher Kontakte hergestellt wurden.

Um eine Justierung und Ausrichtung der Blisterpackungsanordnung quer zur Einschubrichtung P in bezug auf das Aufnahmeteil 23 sicherzustellen, weist die Leiterplatte 8 stirnseitig an jeder Seite ihrer Anschlusskontaktfleckreihe 14a bis 14g, 15 eine Ausrichtnut 13 bzw. 13a auf, wobei diese Ausrichtnuten 13 und 13a unsymmetrisch zur Längsmittellinie der Leiterplatte 8 angeordnet sind (vgl. Fig. 4a,b). Im Aufnahmeteil 23 sind entsprechende Nasenteile 29 bzw. 29a (schematisch dargestellt) angeordnet, die in die Ausrichtnuten 13 bzw. 13a eingreifen, wenn die Blisterpackungsanordnung richtig im Aufnahmeteil 23 angeordnet ist. Nur dann können die elektrischen Verbindungen zwischen den Anschlußkontaktflecken 14a bis 14g sowie 15 und 24a bis 24g sowie 25 hergestellt werden.

Es wird darauf hingewiesen, dass in umgekehrter Weise die Nasenteile an der Blisterpackungsanordnung und die Ausrichtnuten an dem Aufnahmeteil 23 angeordnet sein können.

Ebenso ist es auch denkbar, den Anschlusskontaktfleck 15 entsprechend den individuellen Anschlusskontaktflecken 14a bis 14g auszugestalten und statt dessen den gemeinsamen Anschlusskontaktfleck 25 im Aufnahmeteil 23 in der Einschubrichtung P kürzer auszugestalten als die individuellen Kontaktflecken im Aufnahmeteil 23, sodass beim Einschieben der Blisterpackungsanordnung in das Aufnahmeteil 23 der Kontakt zwischen dem gemeinsamen Anschlusskontaktfleck 25 des Aufnahmeteiles 23 und dem gemeinsamen Anschlusskontaktfleck 15 der Leiterplatte 8 später hergestellt wird als die Kontakte zwischen den individuellen Anschlusskontaktflecken 24a bis 24g des Aufnahmeteiles 23 und den individuellen Anschlusskontaktflecken 14a bis 14g der Leiterplatte 8.

Im folgenden wird ein weiteres wesentliches Merkmal der vorliegenden Erfindung erläutert:

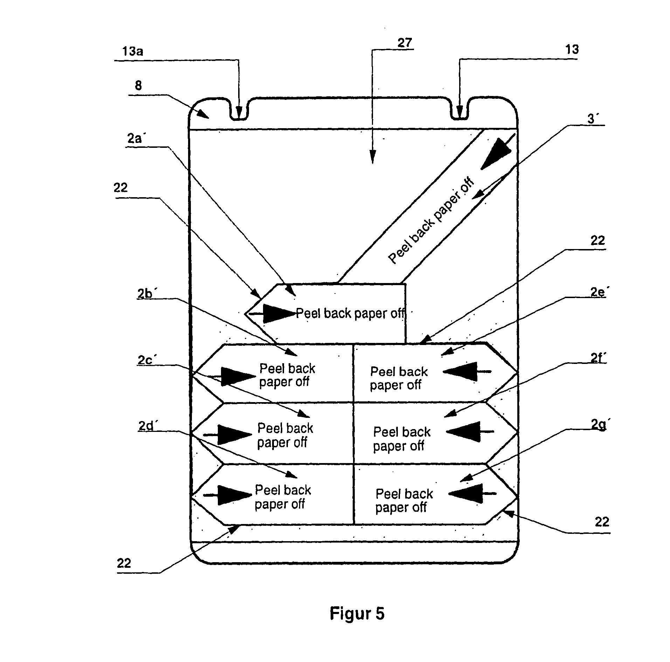

Auf der Unterseite der Leiterplatte 8 wird in der aus der Figur 5 ersichtlichen Weise eine weitere, vorzugsweise aus papierähnlichem Material bestehende Deckschicht 27 aufgebracht, die jeder individuellen Tasche 2a bis 2g bzw. dem Abteil 3 der Blisterpackung 1 zugeordnet, einen Abziehbereich 3' bzw. 2a' bis 2g' aufweist, der den Randbereich der entsprechenden Tasche bzw. des Abteils überdeckt. Beim Gebrauch der Blisterpackungsanordnung muß vor dem Ausdrükken eines Dragees bzw. vor dem Öffnen des Abteils 3 der entsprechende Abziehbereich abgezogen werden.

Die Abziehbereiche 2a' bis 2g' und 3' sind durch eine durch Kraftaufbringung lösbare Klebeverbindung mit der Unterseite der Leiterplatte 8 und über Einstanzlinien 22 mit der Deckschicht 27 lösbar verbunden.

Hierdurch wird erreicht, dass Kleinkinder (in der Regel bis zum Alter von 42 Monaten) im Rahmen des ihnen eigenen Spieltriebes Dragees aus einem Arzneimittelbehälter entnehmen, weil sie in der Regel nicht in der Lage sind, zwei verschiedene Fakten, nämlich das Abziehen des Abziehstreifens und nachfolgend das Ausdrücken eines Dragees, auszuführen.

Gemäß Figur 4, 4a,b ist es denkbar, in den über die Blisterpackung(1)überstehenden Längsrändern der Leiterplatte 8 in der Einschubrichtung verlaufende Schlitze 12 vorzusehen, die in entsprechende Vorsprünge (nicht dargestellt) des Aufnahmeteiles 23 bzw. der Haltevorrichtung eingreifen, wenn die Blisterpackungsanordnung im Aufnahmeteil 23 die richtige Lage erreicht. Auf diese Weise wird ein gegen unbeabsichtigtes Herausziehen gesicherter Halt der Blisterpackungsanordnung im Aufnahmeteil 23 gewährleistet.

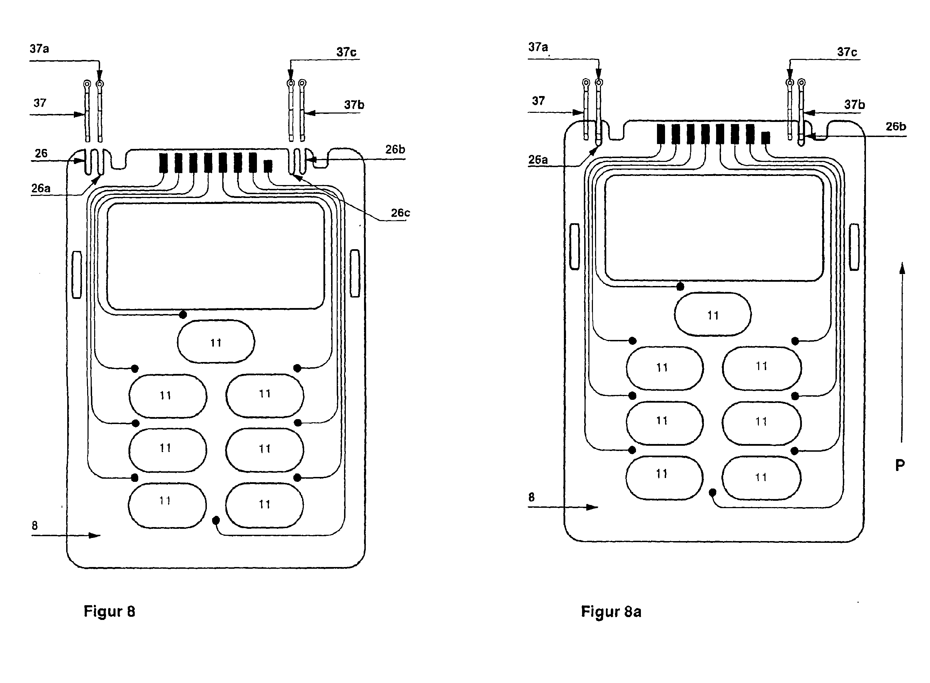

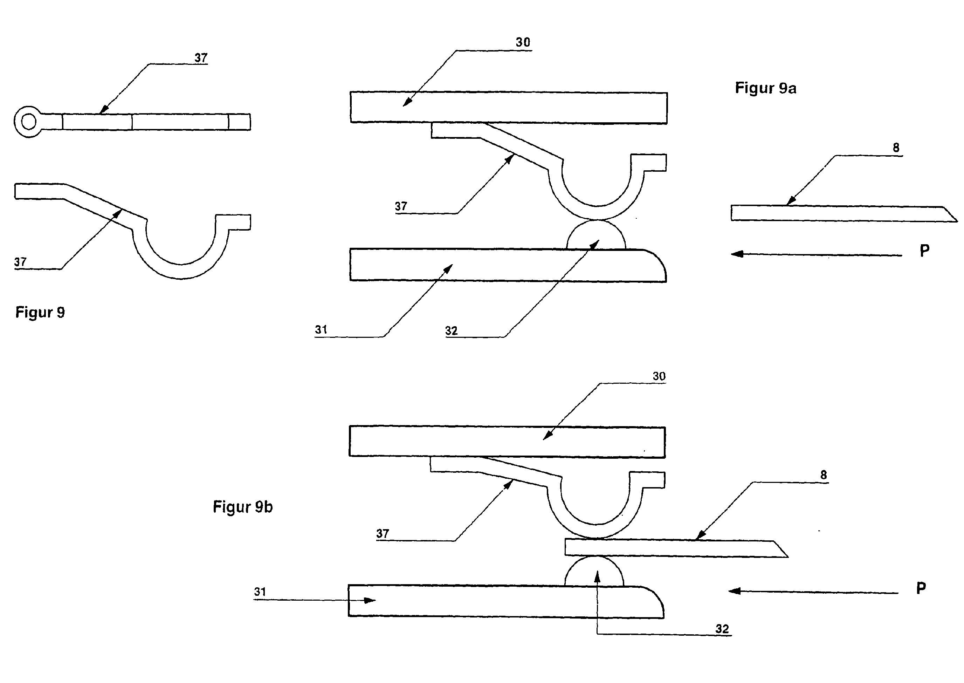

Um eine Anzeige des jeweiligen Blisterpackungsinhaltes zu ermöglichen, kann die Blisterpackung 1 die bereits erwähnten Kodierungen aufweisen, die durch die Elektroneinheit erfassbar sind. Eine bevorzugte Ausführungsform geht aus den Figuren 8, 8a; 9, 9a und 9b hervor

In der Blisterpackung 1 sind in der in das Aufnahmeteil 23 einzuschiebenden Stirnseite Kodierungsnuten 26, 26a - c angeordnet, die mit Kontaktfedern 37, 37a bis c zusammen wirken, die in dem Aufnahmeteil 23 zweckmäßigerweise in der Einschubrichtung P angeordnet sind. Die Figur 9 (oben) zeigt eine solche Kontaktfeder 37 von oben gesehen, während die Figur 9 (unten) die Kontaktfeder 37 von der Seite zeigt. Im Aufnahmeteil 23 sind die Kontaktfedern 37 gemäß den Figuren 9a und 9b so an einer oberen Leiterplatte 30 befestigt, dass ihre Kontaktbereiche federnd an einem Kontaktfleck 32 einer unteren, der oberen Leiterplatte 30 gegenüberliegenden Leiterplatte 31 anliegen.

Je nachdem, ob die Kontaktfedern 37, 37a - c beim Einschieben der Blisterpackungsanordnung in der Einschubrichtung P auf eine Kodierungsnut 26, 26a - c treffen oder nicht, wird der Kontakt zwischen Kontaktfeder und Kontaktfleck unterbrochen oder nicht. Auf diese Weise können bei z.B. vier Kontaktfedern je nach vorbestimmter Zuordnung von Kodierungsnuten oder keinen Kodierungsnuten 16 verschiedene Aussagen über den Inhalt bzw. die Art der Blisterpackung 1 getroffen und von der Elektronikeinheit erfasst bzw. angezeigt werden.

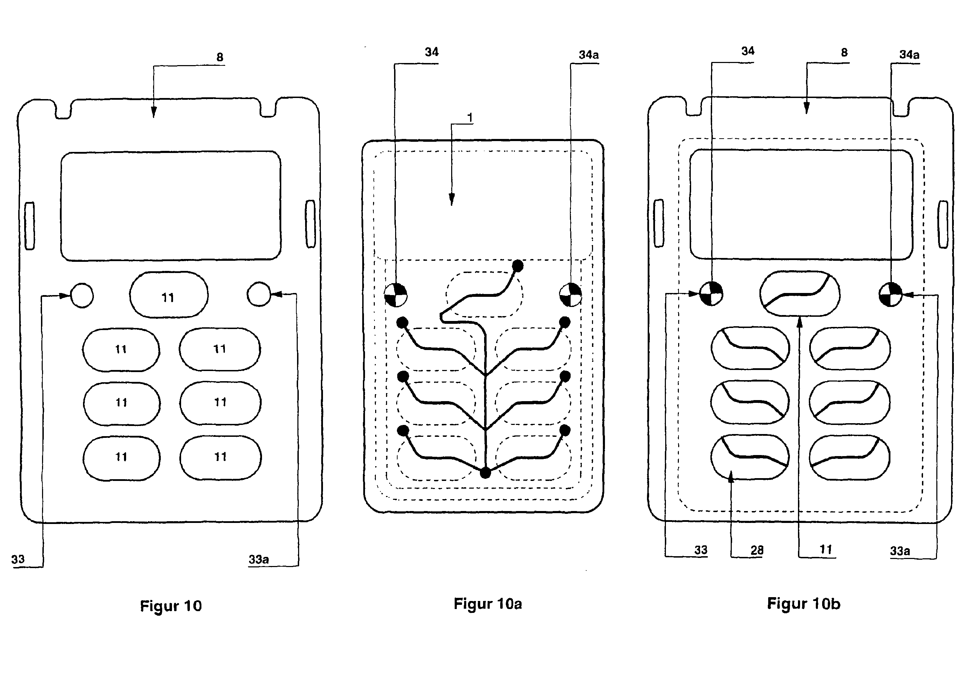

Im Zusammenhang mit den Figuren 10, 10a und 10b wird nun ein bevorzugtes Verfahren zum Aufbringen der Leiterplatte 8 auf der Folie 28 der Blisterpackung 1 erläutert. Die Leiterplatte 8 weist hierzu Fenster 33, 33a auf, die in der richtigen Fixierungslage zu Passermarken 34, 34a ausgerichtet sind, die auf der Folie 28 der Blisterpackung 1 aufgebracht sind. Nachdem z.B. die Kontaktflecken 5a - g und 6 der Blisterpackung 1 mit Leitkleberpunkten 19 versehen sind, werden die einzelnen bahnförmig hintereinander angeordneten Blisterpackungen 1 in ihrer Längsrichtung verfahren, wobei von oben her ebenfalls bahnförmig hintereinander angeordnete Leiterplatten 8 angenähert und schließlich parallel zu den Blisterpackungen 1 verfahren werden, bis eine vorzugsweise optische Sensorik erkennt, dass die Fenster 33, 33a einer Leiterplatte 8 zu den Passermarken 34, 34a einer Blisterpackung 1 ausgerichtet sind. Sobald dies der Fall ist, wird die Leiterplatte 8 gegen die Blisterpackung 1 gedrückt und mit der Folie 28 derselben verbunden, insbesondere verklebt.

## Patentansprüche

1. Blisterpackungsanordnung mit einer Blisterpackung (1), die durch eine Folie (28) verspiegelte Taschen (2a - 2g) aufweist und in ein Aufnahmeteil (23) einer Haltevorrichtung einschiebbar ist, wobei auf der Folie (28) der Blisterpackung (1) außenseitig individuelle Kontaktflecken (5a - 5g) angeordnet sind, von denen jeweils einer einer Tasche (2a - 2g) zugeordnet: ist, wobei von jedem individuellen Kontaktfleck (5a - 5g) aus eine individuelle Leiterbahn (5a' - 5g') auf der Außenseite der Folie (28) über die entsprechende Tasche (2a - 2g) zu einer gemeinsamen Leiterbahn (7) verläuft, die mit einem gemeinsamen Kontaktfleck (6) auf der Außenseite der Folie (28) verbunden ist, wobei bei der Entnahme eines Dragees (20) aus einer Tasche (2a - 2g) die dieser Tasche zugeordnete individuelle Leiterbahn unterbrochen wird, wobei eine Leiterplatte (8) vorgesehen ist, die entsprechend dem Muster der Taschen (2a - 2g) der Blisterpackung (1) Durchstanzungen (11) aufweist, **dadurch gekennzeichnet, dass** die Leiterplatte (8) entsprechend dem Muster der individuellen Kontaktflecken (5a - 5g) und des gemeinsamen Kontaktfleckes (6) der Blisterpackung (1) individuelle Kontaktflecken (9a - 9g) und einen gemeinsamen Kontaktfleck (10) aufweist, wobei die individuellen Kontaktflecken (9a - 9g) der Leiterplatte (8) zu den individuellen Kontaktflecken (5a - 5g) der Blisterpackung (1), der gemeinsame Kontaktfleck (10) der Leiterplatte (8) zu dem gemeinsamen Kontaktfleck (6) der Blisterpackung (1) und die Durchstanzungen (11) der Leiterplatte (8) zu den Taschen (2a - 2g) der auf der Blisterpackung (1) befestigten Leiterplatte (8) ausgerichtet sind, dass die sich entsprechenden individuellen Koncaktflecken (9a - 9g) der Leiterplatte (8) und die individuellen Kontaktflecken (5a - 5g) der Folie (28) der Blisterpackung (1) sowie der gemeinsame Kontaktfleck (10) der Leiterplatte (8) und der gemeinsame Kontaktfleck (6) der Folie (28) der Blisterpackung (1) elektrisch miteinander verbunden sind, dass die Leiterplatte (8) in einem Randbereich individuelle Anschlußkontaktflecken (14a - 14g), die über jeweils eine individuelle Leiterbahn (14) mit einem individuellen Kontaktfleck (9a - 9g) der Leinerplatte (8) verbunden sind und einen gemeinsamen Anschlußkontaktfleck (15) aufweist, der über eine gemeinsame Leiterbahn (17) mit dem gemeinsamen Kontaktfleck (10) der Leiterplatte (8) verbunden ist, und
dass die Verbindungen zwischen den individuellen Kontaktflecken (9a - 9g) der Leiterplatte (8) und den entsprechenden individuellen Kontaktflecken (5a - 5g) der Blisterpackung (1) sowie dem gemeinsamen Kontaktfleck (10) der Leiterplatte (8) und dem gemeinsamen Kontaktfleck (6) der Blisterpackung (1) jeweils über Leitkleberpunkte (19) hergestellt sind.

2. Blisterpackungsanocdnung nach Anspruch 1, **dadurch gekennzeichnet, dass** auf der leiterbahnenfreien Seite der Leiterplatte (8) eine Deckschicht (27) mit Abziehbereiche (2a' - 2g', 3') befestigt ist, die zur Freigabe der zu den Taschen (2a - 2g) der Blisterpackung (1) ausgerichteten Durchstanzungen (11) der Leiterplatte (8) aus der Deckschicht (27) abtrennbar sind.

3. Blisterpackungsanordnung nach Anspruch 2, **dadurch gekennzeichnet, dass** die Abziehbereiche (2a' - 2g') der Deckschicht über Einstanzlinien (22) mit der Deckschicht (27) verbunden sind.

4. Blisterpackungsanordnung nach einem der Ansprüche 1 bis 3, **dadurch gekennzeichnet, dass** die Leiterplatte (8) aus Kunststoff, insbesondere einem PVC-Material, oder aus Pappe besteht.

5. Blisterpackungsanordnung nach einem der Ansprüche 1 bis 4, **dadurch gekennzeichnet, dass** die Leiterplatte (8) flexibel ist.

6. Blisterpackungsanordnung nach einem der Ansprüche 1 bis 5, **dadurch gekennzeichnet, dass** die Blisterpackung (1) neben den Taschen (2a - 2g) ein Abteil (3) zur Aufnahme einer Packungsbeilage oder dergleichen aufweist und dass die Leiterplatte (8) eine zum Abteil (3) ausgerichtete weitere Durchstanzung (16) aufweist.

7. Blisterpackungsanordnung nach Anspruch 6, in Verbindung mit Anspruch 2 **dadurch gekennzeichnet, dass** die Deckschicht (27) einen der weiteren Durchstanzung (16) zugeordneten weiteren Abziehbereich (3') aufweist, aus der Deckschicht (27) heraustrennbar ist.

8. Blisterpackungsanordnung nach einem der Ansprüche 1 bis 7, **dadurch gekennzeichnet, dass** die individuellen Anschlußkontaktflecken (14a - 14g) und der gemeinsame Anschlußkontaktfleck (15) mit entsprechenden individuellen Anschlußkontakten (24a - 24g) bzw. einem gemeinsamen Anschlußkontaktfleck (25) des Aufnahmeteiles (23) der Haltevorrichtung zusammenwirken, wenn die Blisterpackungsanordnung in das Aufnahmeteil (23) eingeschoben ist.

9. Blisterpackungsanordnung nach Anspruch 8, **dadurch gekennzeichnet, dass** die individuellen Anschlußkontaktflecken (14a - 14g) und der gemeinsame Anschlußkontaktfleck (15) an einer Stirnseite der Leiterplatte (8) in einer Reihe quer zur Einschubrichtung (P) angeordnet sind.

10. Blisterpackungsanordnung nach Anspruch 9, **dadurch gekennzeichnet, dass** in der Einschubrichtung (P) gesehen der gemeinsame Anschlußkontaktfleck (15) kürzer bemessen ist als die individuellen Anschlußkontaktflecken (14a - 14g) der Leiterplatte (8).

11. Blisterpackungsanordnung nach Anspruch 9, **dadurch gekennzeichnet, dass** in der Einschubrichtung (P) gesehen die individuellen Anschlußkontaktflecken (14a - 14g) und der gemeinsame Anschlußkontaktfleck (15) der Leiterplatte (8) gleich lang und der gemeinsame Flnschlußkontaktfleck (25) des Aufnahmeteiles (23) kürzer bemessen sind als die individuellen Anschlußkontaktflecken (24a - 24g) des Aufnahmeteiles (23).

12. Blisterpackungsanordnung nach einem der Ansprüche 7 bis 10, **dadurch gekennzeichnet, dass** an der Stirnseite unsymmetrisch zur Längsmittellinie der Blisterpackungsanordnung in der Einschubrichtung (P) wenigstens zwei Ausrichtnuten (13, 13a) angeordnet sind, in die Nasenteile (29, 29a) des Aufnahmeteiles (23) eingreifen, wenn die Blisterpackungsanordnung in das Aufnahmeteil (23) eingeschoben ist

13. Blistarpackungsanordnung nach einem der Ansprüche 7 bis 10, **dadurch gekennzeichnet, dass** an der Stirnseite der Blisterpackungsanordnung Nasenteile (29, 29a) unsymmetrisch zur Längsmittellinie der Blisterpackungsanordnung in der Einschubrichtung (P) angeordnet sind, die in entsprechende Eingriffsnuten des Aufnahmeteiles (23) eingreifen, wenn die Blisterpackungsanordnung in das Aufnahmeteil (23) eingeschoben ist.

14. Blisterpackungsanordnung nach einem der Ansprüche 1 bis 13, **dadurch gekennzeichnet, dass** die Blisterpackung (1) in ihrem Randbereich eine über wenigstens drei Seiten verlaufende Sicke (4) zur Verstärkung aufweist.

15. Blisterpackungsanordnung nach einem der Ansprüche 1 bis 14, **dadurch gekennzeichnet, dass** sie in ihrem Randbereich an sich in der Einschubrichtung (P) gegenüberliegenden Seiten Schlitze (12) oder Vorsprünge aufweist, in die entsprechende Vorsprünge oder Schlitze des Aufnahmeteiles (23) eingreifen, wenn die Blisterpackungsanordnung vollständig in das Aufnahmeteil (23) eingeschoben ist.

16. Blisterpackungsanordnung nach einem der Ansprüche 1 bis 15, **dadurch gekennzeichnet, dass** die Blisterpackungsanordnung auf der Leiterplatte (8) und das Aufnahmeteil (23) Kodierungseinrichtungen zur Anzeige von die Blisterpackung (1) betreffenden Informationen durch die Elektronikeinheit aufweisen.

17. Blisterpackungsanordnung nach Anspruch 16, **dadurch gekennzeichnet, dass** die Kodierungseinrichtung in dem Aufnahmeteil (23) angeordnete Kontaktfedern (37, 37a - c) und auf der Leiterplatte (8) der Blisterpackungsanordnung selektiv angeordnete Kodierungsnuten (26, 26a - c) umfasst, wobei die Kontaktfedern (37, 37a - c) von der eingeschobenen Leiterplatte (8) der Blisterpackungsanordnung von zugeordneten Kontaktflecken (32) getrennt werden, wenn sie nicht auf eine Kodierungsnut treffen oder umgekehrt mit den Kontaktflecken verbunden werden.

18. Bliaterpackungsanordnung nach einem der Ansprüche 1 bis 17, **dadurch gekennzeichnet, dass** in der Leiterplatte (8) durchgehende Fenster (33, 33a) angeordnet sind, die zur Befestigung der Leiterplatte (8) an der Folie (28) der Blisterpackung (1) zu auf dieser angeordnete Passermarken (34, 34a) ausrichtbar sind.

19. Blisterpackungsanordnung nach einem der Ansprüche 1 bis 18, **dadurch gekennzeichnet, dass** die Blisterpackung (1) in ihrem Randbereich durch einen Klebstoff (21) mit der Leiterplatte (8) verbunden ist.

## Claims

1. A blister pack system comprising a blister pack (1) having pockets (2a - 2g) which are sealed by a foil (28) and insertable into a receiving part (23) of a holding device, wherein on the outside of the foil (28) of the blister pack (1), individual contact pads (5a - 5g) are disposed, with each of them being assigned to one of the pockets (2a - 2g), wherein an individual printed conductor (5a' - 5g') runs from each of the individual contact pads (5a - 5g) on the outside of the foil (28) over the corresponding pocket (2a - 2g) to a common printed conductor (7) connected to a common contact pad (6) on the outside of the foil (28), wherein upon removal of a pill (20) from a pocket (2a - 2g), the individual printed conductor assigned to this pocket is interrupted, wherein a printed circuit board (8) is provided having stamped perforations (11) corresponding to the pattern of the pockets (2a - 2g) of the blister pack (1), **characterized in that** the printed circuit board (8) comprises individual contact pads (9a - 9g) and a common contact pad (10) corresponding to the pattern of the individual contact pads (5a - 5g) and the common contact pad (6) of the blister pack (1), wherein the individual contact pads (9a - 9g) of the printed circuit board (8) are aligned with the individual contact pads (5a - 5g) of the blister pack (1), the common contact pad (10) of the printed circuit board (8) is aligned with the common contact pad (6) of the blister pack (1), and the stamped perforations (11) of the printed circuit board (8) are aligned with the pockets (2a - 2g) of the printed circuit board (8) mounted on the blister pack (1); the corresponding individual contact pads (9a - 9g) of the printed circuit board (8) and the individual contact pads (5a - 5g) of the foil (28) of the blister pack (1) as well as the common contact pad (10) of the printed circuit board (8) and the common contact pad (6) of the foil (28) of the blister pack (1) are electrically connected to each other; the printed circuit board (8) has in an edge area individual connection contact pads (14a - 14g), which are each connected to an individual contact pad (9a - 9g) of the printed circuit board (8) via an individual printed conductor (14), and a common connection contact pad (15), which is connected to the common contact pad (10) of the printed circuit board (8) via a common printed conductor (17); and the connections between the individual contact pads (9a - 9g) of the printed circuit board (8) and the corresponding individual contact pads (5a - 5g) of the blister pack (1) as well as the common contact pad (10) of the printed circuit board (8) and the common contact pad (6) of the blister pack (1) are each established by means of conductive adhesive points (19).

2. The blister pack system according to claim 1, **characterized in that** a cover layer (27) with pull-off areas (2a' - 2g', 3') is fixed to the conductor-free side of the printed circuit board (8), with said pull-off areas (2a' - 2g', 3') being removable from the cover layer (27) for the release of the stamped perforations (11) of the printed circuit board (8), which are aligned with the pockets (2a - 2g) of the blister pack (1).

3. The blister pack system according to claim 2, **characterized in that** the pull-off areas (2a' - 2g') of the cover layer (27) are connected to the cover layer (27) via stamped-in lines (22).

4. The blister pack system according to one of claims 1 through 3, **characterized in that** the printed circuit board (8) consists of plastic, in particular a PVC material, or of cardboard.

5. The blister pack system according to one of claims 1 through 4, **characterized in that** the printed circuit board (8) is flexible.

6. The blister pack system according to one of claims 1 through 5, **characterized in that** besides the pockets (2a - 2g); the blister pack (1) has a compartment (3) for receiving a package leaflet or the like, and the printed circuit board (8) has an additional stamped perforation (16) aligned with the compartment (3).

7. The blister pack system according to claim 6 in combination with claim 2, **characterized in that** the cover layer (27) has an additional pull-off area (3') assigned to the additional stamped perforation (16) from which the cover layer (27) is detachable.

8. The blister pack system according to one of claims 1 through 7, **characterized in that** the individual connection contact pads (14a - 14g) and the common connection contact pad (15) interact with corresponding individual connection contact pads (24a - 24g) and/or a common connection contact pad (25) of the receiving part (23) of the holding device when the blister pack system is inserted into the receiving part (23).

9. The blister pack system according to claim 8, **characterized in that** the individual connection contact pads (14a - 14g) and the common connection contact pad (15) are disposed on a front side of the printed circuit board (8) in a row transversely to the insertion direction (P).

10. The blister pack system according to claim 9, **characterized in that**, when viewed in the insertion direction (P), the common connection contact pad (15) is dimensioned shorter than the individual connection contact pads (14a - 14g) of the printed circuit board (8).

11. The blister pack system according to claim 9, **characterized in that**, when viewed in the insertion direction (P), the individual connection contact pads (14a - 14g) and the common connection contact pad (15) of the printed circuit board (8) are of equal length, and the common connection contact pad (25) of the receiving part (23) is dimensioned shorter than the individual connection contact pads (24a - 24g) of the receiving part (23).

12. The blister pack system according to one of claims 7 through 10, **characterized in that** on the front side asymmetrically to the longitudinal center line of the blister pack system in the insertion direction (P), at least two alignment grooves (13, 13a) are disposed, in which projecting parts (29, 29a) of the receiving part (23) engage when the blister pack system is inserted into the receiving part (23).

13. The blister pack system according to one of claims 7 through 10, **characterized in that** on the front side of the blister pack system, projecting parts (29, 29a) are disposed asymmetrically to the longitudinal center line of the blister pack system in the insertion direction (P), which engage in corresponding engagement grooves of the receiving part (23) when the blister pack system is inserted into the receiving part (23).

14. The blister pack system according to one of claims 1 through 13, **characterized in that** in the edge area, the blister pack (1) has a bead (4) extending over at least three sides for reinforcement.

15. The blister pack system according to one of claims 1 through 14, **characterized in that** in the edge area on sides opposite in the insertion direction (P), it has slots (12) or projections, with which corresponding projections or slots of the receiving part (23) engage when the blister pack system is completely inserted into the receiving part (23).

16. The blister pack system according to one of the claims 1 through 15, **characterized in that** the blister pack system on the printed circuit board (8) and the receiving part (23) have coding devices for the display of information relating to the blister pack (1) by means of the electronic unit.

17. The blister pack system according to claim 16, **characterized in that** the coding device comprises contact springs (37, 37a - c) disposed in the receiving part (23) as well as coding grooves (26, 26a - c) selectively disposed on the printed circuit board (8) of the blister pack system, with the contact springs (37, 37a - c) being separated from assigned contact pads (32) by means of the inserted printed circuit board (8) of the blister pack system in the event that they do not encounter a coding groove or, vice versa, are connected to the contact pads.

18. The blister pack system according to one of claims 1 through 17, **characterized in that** in the printed circuit board (8), piercing windows (33, 33a) are disposed, which for fastening the printed circuit board (8) to the foil (28) of the blister pack (1) are alignable with fiducial marks (34, 34a) disposed thereon.

19. The blister pack system according to one of claims 1 through 18, **characterized in that** the blister pack (1) is connected to the printed circuit board (8) in the edge area by means of an adhesive (21).

## Revendications

1. Dispositif d'emballage blister comportant un emballage blister (1) qui présente des poches (2a - 2g) scellées par une feuille (28) et qui peut être inséré dans une partie réceptrice (23) d'un dispositif de retenue, des spots de contact (5a - 5g) individuels étant agencés sur la face extérieure de la feuille (28) de l'emballage blister (1), dont chacun est associé à une poche (2a - 2g), une piste conductrice (5a' - 5g') individuelle s'étendant depuis chaque spot de contact (5a 5g) sur la face extérieure de la feuille (28) via la poche (2a - 2g) correspondante vers une piste conductrice (7) commune qui est reliée à un spot de contact (6) commun sur la face extérieure de la feuille (28), et lors du prélèvement d'un comprimé (20) hors d'une poche (2a - 2g), la piste conductrice (5a' - 5g') associée à cette poche étant interrompue une carte à circuits imprimés (8) étant prévue, laquelle présente des trous estampés (11) selon le motif des poches (2a - 2g) de l'emballage blister (1), **caractérisé en ce que** la carte à circuits imprimés (8) présente, selon le motif des spots de contact (5a - 5g) individuels et du spot de contact (6) commun de l'emballage blister (1), des spots de contact (9a - 9g) individuels et un spot de contact (10) commun, les spots de contact (9a - 9g) individuels de la carte à circuits imprimés (8) étant orientés vers les spots de contact (5a - 5g) individuels de l'emballage blister (1), le spot de contact (10) commun de la carte à circuits imprimés (8) étant orienté vers le spot de contact (6) commun de l'emballage blister (1), et les trous estampés (11) de la carte à circuits imprimés (8) étant orientés vers les poches (2a - 2g) de la carte à circuits imprimés (8) fixée sur l'emballage blister (1), **en ce que** les spots de contact (9a - 9g) individuels correspondants de la carte à circuits imprimés (8) et les spots de contact (5a - 5g) individuels de la feuille (28) dé l'emballage blister (1) ainsi que le spot de contact (10) commun de la carte à circuits imprimés (8) et le spot de contact (6) commun de la feuille (28) de l'emballage blister (1) sont électriquement reliés les uns aux autres, **en ce que** la carte à circuits imprimés (8) présente, dans une zone de bord, des spots de contact de connexion (14a - 14g) qui sont reliés via une piste conductrice (14) individuelle respective à un spot de contact (9a - 9g) individuel de la carte à circuits imprimés (), et un spot de contact de connexion (15) qui est relié via une piste conductrice (17) commune au spot de contact (10) commun de la carte à circuits imprimés (8), et **en ce que** les liaisons entre les spots de contact (9a - 9g) individuels de la carte à circuits imprimés (8) et les spots de contact (5a - 5g) individuels correspondants de l'emballage blister (1) ainsi qu'entre le spot de contact (10) commun de la carte à circuits imprimés (8), et le spot de contact (6) commun de remballage blister (1) sont chacune réalisées par des points d'adhésif conducteur (19).

2. Dispositif d'emballage blister selon la revendication 1, **caractérisé en ce que** sur le côté exempt de pistes conductrices de la carte à circuits imprimés (8) est fixée une couche de recouvrement (27) avec des zones pelables (2a' - 2g', 3') qui peuvent être séparées de la couche de recouvrement (27) pour libérer les trous estampés (11) de la carte à circuits imprimés (8), qui sont orientés vers les poches (2a -2g) de l'emballage blister (1).

3. Dispositif d'emballage blister selon la revendication 2, **caractérisé en ce que** les zones pelables (2a' - 2g') de la couche de recouvrement sont reliées à la couche de recouvrement (27) par des lignes estampées (22).

4. Dispositif d'emballage blister selon l'une des revendications 1 à 3, **caractérisé en ce que** la carte à circuits imprimés (8) est en matière plastique, en particulier en un matériau PVC, ou en carton.

5. Dispositif d'emballage blister selon l'une des revendications 1 à 4, **caractérisé en ce que** la carte à circuits imprimés (8) est flexible.

6. Dispositif d'emballage blister selon l'une des revendications 1 à 5, **caractérisé en ce que** l'emballage blister (1) présente, à côté des poches (2a - 2g), un compartiment (3) pour la réception d'une notice d'utilisation ou similaire, et **en ce que** la carte à circuits imprimés (8) présente un autre trou estampé (16) orienté vers le compartiment (3).

7. Dispositif d'emballage blister selon la revendication 6 en liaison avec la revendication 2, **caractérisé en ce que** la couche de recouvrement (27) présente une autre zone pelable (3') associée à l'autre trou estampé (16), qui peut être séparée de la couche de recouvrement (27).

8. Dispositif d'emballage blister selon l'une des revendications 1 à 7, **caractérisé en ce que** les spots de contact de connexion (14a - 14g) individuels et le spot de contact de connexion (15) commun coopèrent avec des spots de contact de connexion (24a 24g) individuels correspondants et, respectivement, avec un spot de contact de connexion (25) commun de la partie réceptrice (23) du dispositif de retenue, lorsque le dispositif d'emballage blister est inséré dans la partie réceptrice (23).

9. Dispositif d'emballage blister selon la revendication 8, **caractérisé en ce que** les spots de contact de connexion (14a - 14g) individuels et le spot de contact de connexion (15) commun sont agencés dans une rangée, perpendiculairement à la direction d'insertion (P), sur une face frontale de la carte à circuits imprimés (8).

10. Dispositif d'emballage blister selon la revendication 9, **caractérisé en ce que** vu dans la direction d'insertion (P), le spot de contact de connexion (15) commun a des dimensions plus courtes que les spots de contact de connexion (14a - 14g) individuels de la carte à circuits imprimés (8).

11. Dispositif d'emballage blister selon la revendication 9, **caractérisé en ce que** vu dans la direction d'insertion (P), les spots de contact de connexion (14a 14g) individuels et le spot de contact de connexion (15) de la carte à circuits imprimés (8) ont la même longueur, et le spot de contact de connexion (25) de la partie réceptrice (23) a des dimensions plus courtes que les spots de contact (24a-24g) individuels de la partie réceptrice (23).

12. Dispositif d'emballage blister selon l'une des revendications 7 à 10, **caractérisé en ce que** sur la face frontale au moins deux rainures d'orientation (13, 13a) sont agencées dans la direction d'insertion (P) et de manière asymétrique par rapport à la ligne médiane longitudinale du dispositif d'emballage blister, dans lesquelles s'engagent des parties en forme d'ergot (29, 29a) de la partie réceptrice (23) lorsque le dispositif d'emballage blister est inséré dans la partie réceptrice (23).

13. Dispositif d'emballage blister selon l'une des revendications 7 à 10, **caractérisé en ce que** sur la face frontale du dispositif d'emballage blister sont agencées des parties en forme d'ergot (29, 29a) de manière asymétrique par rapport à la ligne médiane longitudinale du dispositif d'emballage blister dans la direction d'insertion (P), lesquels sont insérés dans des rainures d'engagement correspondantes de la partie réceptrice (23) lorsque le dispositif d'emballage blister est inséré dans la partie réceptrice (23).

14. Dispositif d'emballage blister selon l'une des revendications 1 à 13, **caractérisé en ce que** l'emballage blister (1) présente dans sa zone de bord une moulure (4) s'étendant sur au moins trois côtés et servant de renforcement.

15. Dispositif d'emballage blister selon l'une des revendications 1 à 14, **caractérisé en ce que** dans sa zone de bord, sur des côtés se faisant face en direction d'insertion (P), il présente des fentes (12) ou des saillies qui s'engagent dans des saillies ou fentes correspondantes de la partie réceptrice (23) lorsque le dispositif d'emballage blister est entièrement inséré dans la partie réceptrice (23).

16. Dispositif d'emballage blister selon l'une des revendications 1 à 15, **caractérisé en ce que** le dispositif d'emballage blister sur la carte à circuits imprimés (8) et la partie réceptrice (23) présentent des systèmes de codage pour faire afficher par l'unité électronique des informations concernant l'emballage blister (1).

17. Dispositif d'emballage blister selon la revendication 16, **caractérisé en ce que** le système de codage comprend des ressorts de contact (37, 37a - c) agencés dans la partir réceptrice (23) et des rainures de codage (26, 26a - c) agencées sélectivement sur la carte à circuits imprimés (8) du dispositif d'emballage blister, les ressorts de contact (37, 37a - c) étant séparés de spots de contact (32) associés par la carte à circuits imprimés (8) insérée du dispositif d'emballage blister ou, inversement, étant reliés aux spots de contact.

18. Dispositif d'emballage blister selon l'une des revendications 1 à 17, **caractérisé en ce que** dans la carte à circuits imprimés (8) sont agencées des fenêtres (33, 33a) traversantes qui, pour fixer la carte à circuits imprimés (8) sur la feuille (28) de l'emballage blister (1), peuvent être orientées sur des repères (34, 34a) agencés sur celui-ci.

19. Dispositif d'emballage blister selon l'une des revendications 1 à 18, **caractérisé en ce que** dans sa zone de bord, l'emballage blister (1) est relié à la carte à circuits imprimés (8) par un adhésif (21).
